# EUROPÄISCHE PATENTSCHRIFT

(11) **EP 0 396 951 B1**
(45) Veröffentlichungstag und Bekanntmachung des Hinweises auf die Patenterteilung: **27.10.1993**
(21) Anmeldenummer: 90107650.5
(22) Anmeldetag: 23.04.1990
(51) Int. Cl.: H01L 21/00

(54) **Halte- und Transportvorrichtung für eine Scheibe**
Supporting and transporting device for a wafer
Dispositif pour supporter et transporter une plaquette

(30) Priorität: 08.05.1989 DE 3915038
(43) Veröffentlichungstag der Anmeldung: 14.11.1990
(73) Patentinhaber: BALZERS AKTIENGESELLSCHAFT, 9496 Balzers (LI)
(72) Erfinder: Wagner, Rudolf, CH-9476 Fontnas (CH)
(74) Vertreter: Scheidegger, Werner & Co.

(56) Entgegenhaltungen:
- EP-A- 0 228 973
- IBM TECHNICAL DISCLOSURE BULLETIN. vol. 22, no. 1, Juni 1979, NEW YORK US Seiten 120 - 121; HANSEN AND POLONCK: "Convertible wafer size gripper assembly"
- IBM TECHNICAL DISCLOSURE BULLETIN. vol. 29, no. 12, Mai 1987, NEW YORK US Seiten 5614 - 5616; "Vertical casette-to-casette random-access wafer handler"

## Beschreibung

Die Erfindung betrifft eine Halte- und Transportvorrichtung für Transport und Uebergabe einer Scheibe, insbesondere zwischen Stationen innerhalb einer evakuierbaren Kammer einer Vakuumanlage, die mindestens eine bewegbare Scheibenabstützung aufweist, auf die die Scheibe mittels der Halte- und Transportvorrichtung abzulegen ist.

Bei den Scheiben handelt es sich beispielsweise um Halbleiterscheiben, die eine Vielzahl von Behandlungsstufen innerhalb einer Vakuumanlage durchlaufen müssen. Die Vakuumanlage besitzt daher eine Mehrzahl von Prozesskammern für die Halbleiterscheiben und eine zentrale evakuierbare Verteilerkammer, in welche die Halbleiterscheiben über Schleusen eingebracht und aus welcher sie nach der Behandlung wieder ausgebracht werden. Wenn man die Scheiben nach Beendigung der Behandlung in einer Prozesskammer durch die Verteilerkammer zur nächsten Prozesskammer hindurchbefördert, ist bei sehr empfindlichen Prozessen die Gefahr vorhanden, dass Restgase, die beispielsweise in einem Verfahrensschritt in einer Prozesskammer benötigt werden, in eine andere Prozesskammer gelangen, sodass sie den dort durchzuführenden anschliessenden Prozess stören. Ferner besteht die Gefahr, dass Partikel , die bei einem der Prozesse aufgewirbelt werden, bei dem Transport in die nächste Prozesskammer verschleppt werden. Auch vom Aussenraum können mit den noch unbehandelten Halbleiterscheiben Partikel in die Verteilerkammer eingebracht werden und beim Vorbeibewegen an den teilweise bereits behandelten Halbleiterscheiben auf diese gelangen, sodass ein nachfolgend durchzuführender Prozess dadurch beeinträchtigt wird. Um dies zu vermeiden, ist zwischen der Verteilerkammer und der mindestens einen Prozesskammer eine evakuierbare Zwischenkammer vorgesehen, die mittels Ventilen abdichtbar ist. Zwischen verschiedenen Behandlungsstufen in mehreren Prozesskammern kommen die Halbleiterscheiben mit der Verteilerkammer nicht in Kontakt, sodass die Gefahr der Verschleppung von Restgasen oder von Partikeln sich weitgehend ausschliessen lässt.

In der Verteilerkammer befindet sich eine Tranporteinrichtung, die geeignet ist, aus einer vor der Verteilerkammer befindlichen Schleusenkammer die dort in einem Magazin übereinander befindlichen Scheiben dem Magazin zu entnehmen, wobei diese Transporteinrichtung vorzugsweise ein unter die Scheibe in dem Magazin fahrender Robotarm ist. Wenn nun an die Verteilerkammer anschliessende und abdichtbare Zwischenkammern vorhanden sind, von denen aus erst der Weitertransport in die Prozesskammern erfolgt, so muss eine weitere Transporteinrichtung in den Zwischenkammern vorhanden sein, die jeweils eine Scheibe von dem Robotarm übernehmen.

Der vorliegenden Erfindung lag daher die Aufgabe zugrunde, eine Halte- und Transportvorrichtung für Transport und Uebergabe eines scheibenförmigen Körpers bzw. einer Scheibe ganz generell und insbesondere eine solche Transporteinrichtung für eine Zwischenkammer zu schaffen, die die Bedingungen erfüllen muss, mehrere an eine Zwischenkammer angrenzende Prozesskammern jeweils mit einer Scheibe zu beschicken und eine Scheibe von den Robotarm für den Weitertransport derart zu übernehmen , dass kein Kontakt zwischen den beiden Transporteinrichtungen stattfindet, um das Verschleppen von Partikeln auf diesem Weg völlig auszuschliessen. Zur Lösung der allgemeinen und der spezifischen Aufgabe weist die Halte- und Transportvorrichtung der eingangs genannten Art die Merkmale nach Anspruch 1 auf. Zwischenkammern mit je einer solchen Halte- und Transportvorrichtung können in Mehrzahl um eine im Zentrum befindliche Verteilerkammer herum angeordnet sein. Wenn der in der Verteilerkammer vorhandene und nicht zur Erfindung gehörende Robotarm, der ein- und ausfahrbar ist und nach Oeffnen des zwischen der Verteilerkammer und einer Zwischenkammer vorhandenen Ventils in die Zwischenkammer hineinfährt, die zu behandelnde Scheibe unterseitig abstützt, so muss die in der Zwischenkammer vorhandene Halte- und Transportvorrichtung die Scheibe am Umfangsrand halten, damit die Uebergabe der Scheibe ohne jeden Kontakt zwischen den Transporteinrichtungen erfolgen kann. An eine Zwischenkammer können an ihrer Oberseite wiederum eine Mehrzahl von abdichtbaren Prozesskammern angrenzen, die sich somit eine Etage höher befinden und in die die Scheiben mit Hilfe von in der Zwischenkammer angeordneten Hubtischen gelangen, deren Mittelpunkte auf einem Kreis liegen. Die erfindungsgemässe Halte- und Transportvorrichtung hat dann die Aufgabe, jeweils eine Scheibe auf einem der Hubtische abzulegen, weshalb die erfindungsgemässe Halte- und Transportvorrichtung in bevorzugter Weise um eine zentrale Achse schwenkbar ist, um auf jedem der vorhandenen Hubtische eine Scheibe deponieren zu können.

Weitere Einzelheiten und Vorteile der Erfindung ergeben sich aus der nachfolgenden Beschreibung und den Zeichnungen, in denen eine Ausführungsform der Erfindung rein beispielsweise dargestellt ist. Es zeigen:
Fig. 1 in Draufsicht das Schema einer Vakuumanlage mit einer Verteilerkammer und drei Zwischenkammern mit an jeder derselben angrenzenden drei Prozesskammern;
Fig. 2 die Halte- und Transportvorrichtung teilweise horizontal geschnitten und schematisch in ihrer Zuordnung zu drei Hubtischen;
Fig. 3 die Vorrichtung gemäss Fig. 2 in grösserem Massstab und in zwei unterschiedlichen Ausführungsformen.

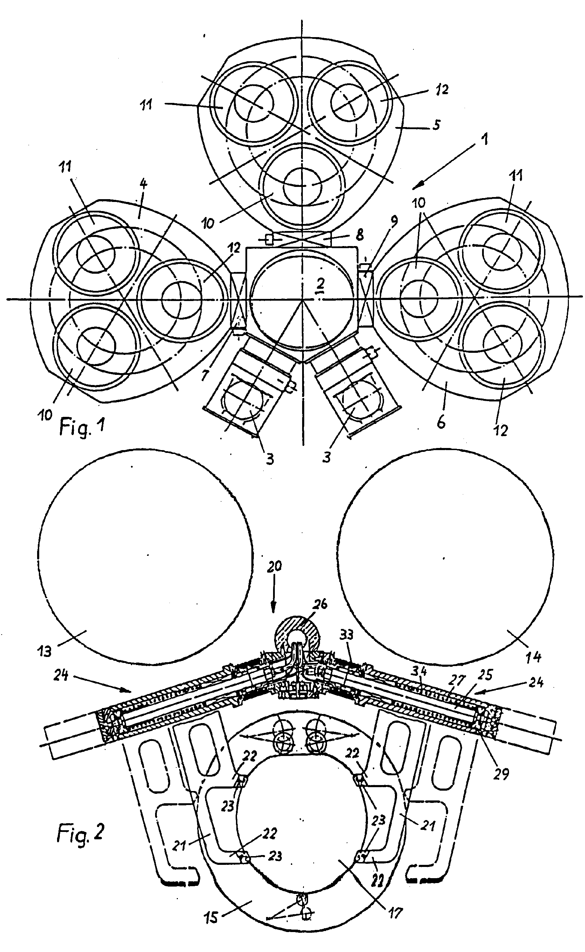

Die in Fig. 1 schematisch dargestellte Vakuumanlage 1 weist eine zentrale Verteilerkammer 2 auf, in welche die zu behandelnden Halbleiterscheiben über Schleusenkammern 3 eingebracht bzw. nach der Behandlung wieder ausgebracht werden. An die Verteilerkammer 2 schliessen sich an drei Seiten Zwischenkammern 4, 5 und 6 an, wobei zwischen diesen und der zentralen Verteilerkammer 2 Ventile 7, 8 und 9 angeordnet sind, die von einer nicht näher dargestellten Steuereinrichtung den durchzuführenden Prozessen entsprechend geöffnet und geschlossen werden. Oberhalb jeder der Zwischenkammern 4, 5 und 6 befinden sich jeweils drei abdichtbare Prozesskammern 10, 11 und 12. In diese werden die zu behandelnden Scheiben mit Hilfe je eines Hubtisches eingebracht, was nicht weiter dargestellt ist, wobei der hochgefahrene Hubtisch gleichzeitig die Verbindung zwischen Prozesskammer und Zwischenkammer abschliesst, sodass in der dann abgedichteten Prozesskammer die Behandlung der Scheibe durchgeführt wird.

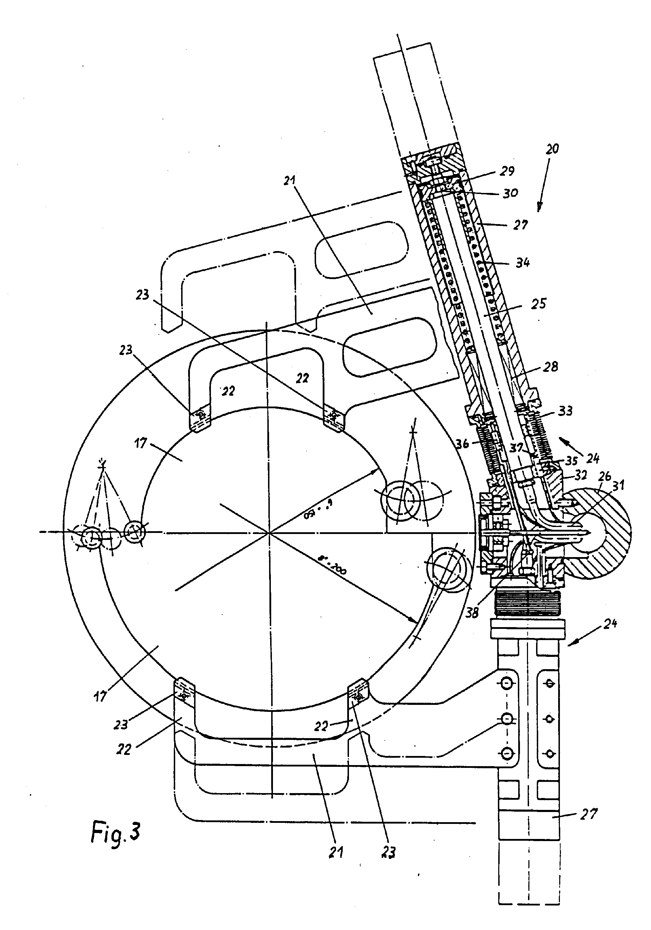

Im Zentrum jeder der Zwischenkammern 4, 5 und 6 befindet sich jeweils eine erfindungsgemässe Halte- und Transportvorrichtung gemäss Fig. 2, die in Fig. 1 nicht dargestellt ist. Um die Scheiben in die oberhalb der Zwischenkammer auf einem Kreis angeordneten Prozesskammern zu bringen, sind in Fig. 2 schematisch als Kreise dargestellte drei Hubtische 13, 14 und 15 erforderlich. Diese Hubtische befinden sich genau unterhalb der Prozesskammern 10, 11 und 12. Fig. 2 zeigt demnach im grösseren Massstab die in der Zwischenkammer 5 vorhandenen Einbauten schematisch dargestellt.

Der in der Verteilerkammer 2 vorhandene, nicht dargestellte Robotarm transportiert eine zu behandlende Scheibe 17 in die Zwischenkammer 5 hinein und über den dort vorhandenen Hubtisch 15. Die Scheibe 17 wird dort von der erfindungsgemässen Halte- und Transportvorrichtung 20 übernommen, welche in Fig. 3 in grösserem Massstab dargestellt ist, wobei in Fig. 3 zwei verschiedene Ausführungsformen dargestellt sind, die ausserdem für im Durchmesser verschieden grosse zu behandelnde Scheiben zum Einsatz gelangen. Die Vorrichtung 20 gemäss Fig. 2 ist demnach nur in der oberen Hälfte der Fig. 3 dargestellt und diese bezüglich der Symmetrieachse spiegelbildlich ergänzt zu denken.

Die Vorrichtung 20 weist zwei spiegelbildlich gleich ausgebildete Haltearme 21 auf, die jeweils zwei im Abstand voneinander angeordnete Finger 22 besitzen und an den Fingerenden Abstützflächen 23, die sich alle in der gleichen Ebene befinden und die in der mit ausgezogenen Linien dargestellten Stellung der Haltearme 21 in Fig. 2 und 3 die zu behandelnde Scheibe 17 an ihrem Rand an vier umfangsmässig verteilt liegenden Randpartien abstützen, wobei die Haltearme nicht gegen den Umfang der Scheibe andrücken dürfen.Um den gegenseitigen Abstand der beiden Haltearme 21 zu verkleinern oder zu vergrössern bzw. um die Haltearme gleichzeitig auf das Zentrum der Scheibe 17 zu- oder von diesem wegzubewegen, ist jeder der Haltearme 21 an einer Kolben/Zylinder-Einheit 24 befestigt. Von zwei gleichen und spiegelbildlich angeordneten Kolben/Zylinder-Einheiten 24 sind die Enden der Kolbenstangen 25 einander gegenüber an einer zu den Achsen der Kolben/Zylinder-Einheiten senkrechten Drehachse 26 befestigt. Diese ist innerhalb der jeweiligen Zwischenkammer 4 bzw. 5 oder 6 drehbar angeordnet. Auf der fest angeordneten Kolbenstange 25 ist ein Zylinder 27 verdrehungssicher geführt und an diesem Zylinder ist der Haltearm 21 aussen befestigt. Zur Führung dient eine Kugellagerbüchse 28 zwischen der Kolbenstange 25 und den Zylinder 27, welche so ausgebildet ist, dass eine Verdrehung von Kolbenstange und Zylinder relativ zueinander nicht möglich ist. Die Kolbenstange 25 ist hohl und trägt an ihrem vom Befestigungsende abgewandten Ende einen Kolben 29 mit einer axialen Bohrung 30. An das befestigte Ende der Kolbenstange 25 ist eine Leitung 31 für ein Druckmedium angeschlossen, beispielsweise Druckluft. Beide Leitungen 31, die zu den beiden Kolben/Zylinder-Einheiten 24 führen, erstrecken sich durch die hohle Drehachse 26, welche ausserdem einandergegenüberliegend je einen Flansch 32 trägt, an dem das eine Ende eines Metallfaltenbalgs 33 befestigt ist, dessen anderes Ende am freien Ende des Zylinders 27 befestigt ist. Bei Betätigung der Kolben/Zylinder-Einheit 24 bewegt sich der Zylinder 27 durch den Druck des Druckmediums in die strichpunktierte Lage nach aussen und der Haltearm 21 nimmt dann die ebenfalls strichpunktierte Lage ein. In dieser Lage befindet sich ,jeder der Haltearme 21 gerade ausserhalb des darunter befindlichen Hubtisches 15, sodass dieser Hubtisch nach dem Ablegen der zu behandelnden Scheibe 17 auf die Hubtischoberfläche an den Haltearmen vorbei nach oben bis in die Prozesskammer fahren kann.

Die entgegengesetzte Bewegung des Zylinders 27 in die Ausgangslage erfolgt durch die Kraft einer Schraubendruckfeder 34, die die Kolbenstange 25 umschliesst und die mit ihrem einen Ende am Kolben 29 und mit dem anderen Ende am Zylinder 27 abgestützt ist. Für beide Endstellungen des ein- und ausfahrbaren Zylinders 27 sind unterhalb des Metallfaltenbalgs 33 Sensorelemente 35 und 36 angeordnet. Wenn der Zylinder 27 eingefahren ist, steht unmittelbar vor dem Sensorelement 35 ein am Zylinder 27 befestigter und mit diesem sich mitbewegender Finger 37, während ein weiteres Fingerende 38 bei ausgefahrenem Zylinder 27 vor das Sensorelement 36 zu liegen kommt.

Die Kolben/Zylinder-Einheiten 24 werden gleichzeitig mittels Druckluft betätigt und da sie in einer evakuierbaren Zwischenkammer 4 bzw. 5 bzw. 6 angeordnet sind, müssen sie hermetisch abgedichtet sein, was durch den Metallfaltenbalg 33 erreicht ist.

In Fig. 2 sind schematisch drei Hubtische 13, 14 und 15 dargestellt, deren Zentren auf einem Kreis mit einer Winkelteilung von 120° liegen. Die Hubtische bewegen sich wie erwähnt parallel zur Drehachse 26 auf und ab, und damit die Hubtische eng zusammenstehend angeordnet werden können, schliessen die beiden Zylinder 27 der Vorrichtung gemäss Fig. 2, die in dem freien Raum zwischen benachbarten Hubtischen angeordnet werden müssen, einen stumpfen Winkel miteinander ein. Wenn die Platzverhältnisse diese Anordnung der Zylinder nicht verlangen und beispielsweise nur ein Hubtisch oder zwei einander gegenüberliegende Hubtische vorhanden sind, können die beiden Kolben/Zylinder-Einheiten 24 in der Weise, wie in Fig. 3 in der unteren Hälfte dargestellt ist, also in geradliniger Verlängerung einander gegenüberstehend angeordnet werden. In Fig. 3 ist erkennbar, dass die Haltearme 21 aussen an der Oberseite des Zylinders 27 jeweils befestigt sind. Ausserdem geht aus Fig. 3 hervor, dass mit der Vorrichtung und den Haltearmen 21 im Durchmesser verschieden grosse zu behandelnde Scheiben 17 gehalten und transportiert werden können. In der oberen Hälfte der Fig. 3 ist eine kleinere und in der unteren Hälfte eine im Durchmesser grössere Scheibe dargestellt, die auf dem gleichen Hubtisch 15 abgelegt wird und es versteht sich, dass bei der grösseren Scheibe der Weg des Haltearms bis in die strichpunktierte Stellung ausserhalb des Hubtisches 15 und damit auch der erforderliche Hub des Zylinders 27 der Vorrichtung kleiner ist als bei der in der oberen Hälfte der Fig. 3 dargestellten kleineren Scheibe.

## Patentansprüche

1. Halte- und Transportvorrichtung für Transport und Uebergabe einer Scheibe, dadurch gekennzeichnet, dass zwei im Wesentlichen spiegelbildlich ausgebildete Haltearme (21) mit jeweils mindestens zwei im Abstand voneinander angeordneten Fingern (22) und in der gleichen Ebene befindlichen Abstützflächen (23) an den Fingerenden zum Unterstützen des Scheibenrands (17) an mindestens vier am Umfang verteilt liegenden Randpartien mittels zweier gleichzeitig betätigbarer Bewegungseinrichtungen (24), von denen jede einen Haltearm (21) trägt, zwecks Verkleinerung oder Vergrösserung ihres gegenseitigen Abstandes gleichzeitig auf das Scheibenzentrum zu oder von diesem weg bewegbar sind, um eine Scheibe (17) zu halten oder freizugeben.

2. Vorrichtung nach Anspruch 1, dadurch gekennzeichnet, dass mindestens eine der Bewegungseinrichtungen eine mittels eines Druckmediums betätigbare Kolben/Zylinder-Einheit (24) ist und der zugeordnete Haltearm (21) aussen am relativ zur fest angeordneten Kolbenstange (25) bewegbaren Zylinder (27) befestigt ist, welcher auf der Kolbenstange (25) vorzugsweise verdrehungssicher geführt ist.

3. Vorrichtung nach Anspruch 1 oder 2, dadurch gekennzeichnet, dass die Bewegungseinrichtungen im Wesentlichen V-förmig angeordnet sind und an einer zu deren Bewegungsrichtung vorzugsweise senkrechten, gemeinsamen Drehachse (26) befestigt sind, wobei beide Einrichtungen (24) zwecks Schwenken der Haltearme (21) auf einer Kreisbahn verschwenkbar sind.

4. Vorrichtung nach Anspruch 2 oder 3, dadurch gekennzeichnet, dass die Kolbenstange (25) als Leitung für das Druckmedium hohl ist und einen im Zylinder (27) abgedichtet geführten und mit einer axialen Bohrung (30) versehenen Kolben (29) trägt, relativ zu welchem der Zylinder (27) durch den Druck des Druckmediums eine Hubbewegung gegen eine Federkraft zwecks Aenderung des gegenseitigen Abstandes der an den Zylindern angeordneten Haltearme (21) ausführt.

5. Vorrichtung nach Anspruch 4, dadurch gekennzeichnet, dass das Ende des relativ zur Kolbenstange (25) bewegbaren Zylinders (27) durch einen Metallfaltenbalg (33) mit einem an der Drehachse (26) befestigten Flansch (32) verbunden ist, zwecks Abdichtung der gesamten in der evakuierbaren Kammer (4,5,6) befindlichen Kolben/Zylinder-Einheit (24).

6. Vorrichtung nach Anspruch 5, dadurch gekennzeichnet, dass eine Druckmedium-Zuleitung (31) für die Bewegungseinrichtungen durch die hohl ausgebildete Drehachse (26) geführt ist.

7. Vorrichtung nach einem der Ansprüche 1-6, dadurch gekennzeichnet, dass die Bewegungseinrichtungen (24) als doppeltwirkende Kolben/Zylinder-Einheiten ausgebildet sind.

8. Vorrichtung nach einem der vorhergehenden Ansprüche, dadurch gekennzeichnet, dass den Bewegungseinrichtungen (24) Sensorenelemente (35-38) für die elektrisch übermittelte Anzeige der jeweiligen Hubstellung zugeordnet sind.

## Claims

1. A holding and transporting device for transporting and transferring a disc characterised in that two holding arms (21) of substantially mirror-image configuration, each having at least two spaced-apart fingers (22) and support surfaces (23) disposed in the same plane at the finger ends for supporting the disc edge (17) at at least four circunferentially distributed edge parts are simultaneously movable towards the disc centre or away from same by means of two simultaneously actuable motion devices (24), each of which carries a holding arm (21), for the purposes of reducing or increasing their mutual spacing, in order to hold or release a disc (17).

2. A device according to claim 1 characterised in that at least one of the motion devices is a piston-cylinder unit (24) which is actuable by means of a pressure medium and the associated holding arm (21) is fixed on the outside to the cylinder (27) which is movable relative to the fixedly arranged piston rod (25) and which is guided preferably non-rotatably on the piston rod (25).

3. A device according to claim 1 or claim 2 characterised in that the motion devices are arranged substantially in a V-shape and are fixed to a common pivot axis member (26) which is preferably perpendicular to their direction of motion, wherein both devices (24) are pivotable on a circular path for the purposes of pivotal movement of the holding arms (21).

4. A device according to claim 2 or claim 3 characterised in that the piston rod (25) is hollow to act as a conduit for the pressure medium and carries a piston (29) which is sealingly guided in the cylinder (27) and which is provided with an axial bore (30) and relative to which the cylinder (27), by virtue of the pressure of the pressure medium, performs a stroke movement against a spring force for the purposes of altering the mutual spacing of the holding arms (21) arranged on the cylinders.

5. A device according to claim 4 characterised in that the end of the cylinder (27) which is movable relative to the piston rod (25) is connected by a metal bellows (33) to a flange (32) fixed to the pivot axis member (26), for the purposes of sealing off the entire piston-cylinder unit (24) which is disposed in the evacuatable chamber (4, 5, 6).

6. A device according to claim 5 characterised in that a pressure medium feed conduit (31) for the motion devices is passed through the hollow pivot axis member (26).

7. A device according to one of claims 1 to 6 characterised in that the motion devices (24) are in the form of double-acting piston-cylinder units.

8. A device according to one of the preceding claims characterised in that associated with the motion devices (24) are sensor elements (35-38) for the electrically provided display of the respective stroke position.

## Revendications

1. Dispositif de maintien et de transport destiné au transport et au transfert d'un disque, caractérisé en ce que deux bras de maintien (21), conçus de façon sensiblement symétrique, comportant respectivement au moins deux doigts (22) disposés à une certaine distance l'un de l'autre, et des surfaces d'appui (23) situées au même niveau sur les extrémités des doigts, destinées à supporter le bord du disque (17) sur au moins quatre parties du bord réparties sur sa périphérie, peuvent être déplacés simultanément vers le centre du disque ou éloignés de celui-ci au moyen de deux dispositifs de déplacement (24) pouvant être actionnés simultanément, et portant chacun un bras de maintien (21), et ce afin de diminuer ou d'augmenter leur écartement respectif en vue de maintenir ou de libérer un disque (17).

2. Dispositif selon la revendication 1, caractérisé en ce qu'au moins l'un des dispositifs de déplacement est une unité piston/cylindre (24) pouvant être actionnée au moyen d'un fluide sous pression, et en ce que le bras de maintien (21) associé est fixé sur l'extérieur du cylindre (27) qui est mobile par rapport à la tige de piston (25) fixe, lequel est de préférence guidé sur la tige de piston (25) de façon à ne pas pouvoir tourner.

3. Dispositif selon l'une quelconque des revendications 1 ou 2, caractérisé en ce que les dispositifs de déplacement sont sensiblement disposés en forme de V et fixés sur un axe de rotation (26) commun, qui est de préférence perpendiculaire à leur direction de déplacement, étant préciser que les deux dispositifs (24) peuvent pivoter sur une trajectoire circulaire afin d'assurer le pivotement des bras de maintien (21).

4. Dispositif selon l'une quelconque des revendications 2 ou 3, caractérisé en ce que la tige de piston (25) est creuse afin de faire office de conduit pour le fluide sous pression, et porte un piston (29) muni d'un perçage axial (30) inséré de manière étanche dans le cylindre (27), par rapport auquel le cylindre (27), sous l'effet de la pression du fluide sous pression, exerce un mouvement de levage s'opposant à la force d'un ressort afin de modifier l'écartement respectif des bras de maintien (21) disposés sur les cylindres.

5. Dispositif selon la revendication 4, caractérisé en ce que, afin d'assurer l'étanchéité de l'ensemble de l'unité piston/cylindre (24) se trouvant dans la chambre évacuable (4, 5, 6), l'extrémité du cylindre (27) mobile par rapport à la tige de piston (25) est reliée par un soufflet métallique (33) à une bride (32) fixée sur l'axe de rotation (26).

6. Dispositif selon la revendication 5, caractérisé en ce qu'un conduit (31) alimentant en fluide sous pression les dispositifs de déplacement traverse l'axe de rotation (26) de conception creuse.

7. Dispositif selon l'une quelconque des revendications 1 à 6, caractérisé en ce que les dispositifs de déplacement (24) sont conçus sous la forme d'unités piston/cylindre à double effet.

8. Dispositif selon l'une quelconque des revendications précédentes, caractérisé en ce que des éléments de détection (35 à 38) sont associés aux dispositifs de déplacement (24) afin de transmettre électriquement la signalisation de la position respective de levage.
